Europäisches Patentamt

European Patent Office

Office européen des brevets

(19)

(11) **EP 0 735 687 A2**

(12) **EUROPEAN PATENT APPLICATION**

(43) Date of publication:
02.10.1996 Bulletin 1996/40

(51) Int Cl.6: **H03K 19/0185**

(21) Application number: 96302174.6

(22) Date of filing: 28.03.1996

(84) Designated Contracting States:
DE FR GB IT

(30) Priority: 31.03.1995 US 414748

(71) Applicant: SGS-THOMSON
MICROELECTRONICS, INC.
Carrollton Texas 75006-5039 (US)

(72) Inventor: McClure, David C.
Carrollton, Texas 75007 (US)

(74) Representative: Palmer, Roger et al
PAGE, WHITE & FARRER
54 Doughty Street
London WC1N 2LS (GB)

(54) **Output driver with programmable drive characteristics**

(57)     An output driver circuit for an integrated circuit is disclosed, where the output driver drives an output terminal with a high logic level having a voltage limited from the power supply voltage of the integrated circuit. The limited voltage is provided by applying a limited output high voltage to an output buffer, such that the drive signal applied to the gate of the pull-up transistor in the output driver is limited by the limited output high voltage applied to the output buffer. A voltage reference and regulator circuit for generating the limited output high voltage is also disclosed, and is based on a current mirror. The sum of the current in the current mirror is controlled by a bias current source, which may be dynamically controlled within the operating cycle or programmed by way of fuses, so that the output impedance of the voltage reference and regulator circuit may be selected. Slew rate control for output driver transistors is also provided, under the control of a bias circuit that generates a tracking reference voltage; the reference voltage may also be programmed by way of fuses or by control signals, so that the slew rate may also be selected.

*FIG. 1*

## Description

This invention is in the field of integrated circuits, and is more particularly directed to output driver circuits therein.

This application is related to European Patent Application Nos 95308348.2, 95308562.8, 95308559.4, 95308560.2, 95308561.0, 95308543.8 and 95308563.6, the contents of which are incorporated herein by this cross reference.

In the field of modern digital integrated circuits, particularly those fabricated according to the well-known complementary metal-oxide-semiconductor (CMOS) technology and that may be used in low-power applications, such as battery powered computers, the integrated circuit designer is often faced with a difficult tradeoff between device performance and power dissipation. This tradeoff is particularly difficult in the design of output driver circuits, where rapid switching of an output terminal (especially when driving a significant load) generally requires the sourcing and sinking of significant current. Besides the problem of providing adequate current to quickly switch a capacitive load, high performance output drivers can also produce a large amount of noise, primarily due to voltage modulation from the inductive component of data bus impedance, especially in the worst case when multiple output terminals are being switched simultaneously. Optimization of the output driver circuit to provide high performance, with low power dissipation and low noise, is therefore often a difficult task for the circuit designer.

Furthermore, it has been observed that different system applications may place different output drive requirements onto the integrated circuits. Of course, the load presented to an integrated circuit output will vary among system applications. In addition, the speed, power and noise requirements may vary from application to application. While these variations in device requirements may allow the circuit designer to design optimal output driver circuitry for each class of systems, inventory and planning constraints of the integrated circuit manufacturer will generally require the circuit designer to optimize the output driver circuitry over a wide range of expected applications. As a result, the performance of the integrated circuit is generally optimal only for a small portion of the potential market.

It is an object of the present invention to provide output driver circuitry that may be optimized during manufacture for particular requirements.

It is a further object of the present invention to provide such circuitry that may be optimized under user control.

It is a further object of the present invention to provide such circuitry that may be optimized to match the characteristics of the manufactured transistors in the integrated circuit itself.

It is another object of the present invention to provide such circuitry that may be optimized permanently by way of fuse programming.

Other objects and advantages of the present invention will be apparent to those of ordinary skill in the art having reference to the following specification together with its drawings.

The invention may be implemented into output driver circuitry for an integrated circuit. The output driver circuitry includes a pull-up transistor which has its gate drive controlled by an output buffer, according to an output reference voltage. The output reference voltage is generated by a circuit according to a current source based on a current mirror, where one or more parallel legs may be switched into the reference leg. The current source output thus conducts a mirrored current according to the current in the reference leg. The switching in of parallel legs changes the effective mirror ratio, which adjusts the output reference voltage; in addition, a bias reference voltage can also be controlled. Control of these circuit functions, for example by way of fuse programming, bond wire connections, or under control of a logic signal, allows the drive characteristics of the output driver to be programmed at a late stage in the manufacturing process (when fuse programming or wire-bond options are used) or even by the user in the system (when logic signals are used).

Some embodiments of the invention will now be described by way of example and with reference to the accompanying drawings in which:

Figure 1 is an electrical diagram, in block form, of an integrated memory circuit incorporating output drive circuitry according to the preferred embodiment of the invention.

Figure 2 is an electrical diagram, in block form, of the output drive circuitry according to the preferred embodiment of the invention.

Figure 3 is an electrical diagram, in schematic form, of a voltage reference and regulator circuit according to the preferred embodiment of the invention.

Figure 4 is an electrical diagram, in schematic form, of a bias current source as used in the voltage reference and regulator circuit according to the preferred embodiment of the invention.

Figures 5 and 6 are timing plots of the operation of the voltage reference and regulator circuit according to the preferred embodiment of the invention in the absence and presence, respectively, of an offset compensating current.

Figure 7 is an electrical diagram, in schematic form, of a dynamic bias control circuit as used in the voltage reference and regulator circuit according to the preferred embodiment of the invention.

Figure 8 is a timing diagram illustrating the operation of the circuit of Figure 7 in an inteqrated circuit memory.

Figure 9 is an electrical diagram, in schematic form, of a bias current source according to an alternative embodiment of the invention, including programmable bias current levels.

Figure 10 is an electrical diagram, in schematic form, of a voltage reference and regulator circuit according to an alternative embodiment of the invention.

Figure 11 is an electrical diagram, in schematic form, of a bias circuit according to the preferred embodiment of the invention.

Figure 12 is an electrical diagram, in schematic form, of an output buffer circuit according to the preferred embodiment of the invention.

Figure 13 is an electrical diagram, in schematic form, of a bias circuit according to an alternative embodiment of the invention.

As will become apparent from the following description, it is contemplated that the present invention may be implemented into many types of integrated circuits that generate digital output signals. Examples of such integrated circuits include memory circuits of the read-only, programmable read-only, random access (either static or dynamic), and FIFO types, timer circuits, microprocessors, microcomputers, microcontrollers, and other logic circuits of the general or programmable type. For purposes of description, the preferred embodiment of the invention will be described for the example of a memory integrated circuit, as memory circuits are contemplated to be often used to provide output data to an integrated circuit (such as a microprocessor) having a lower power supply voltage.

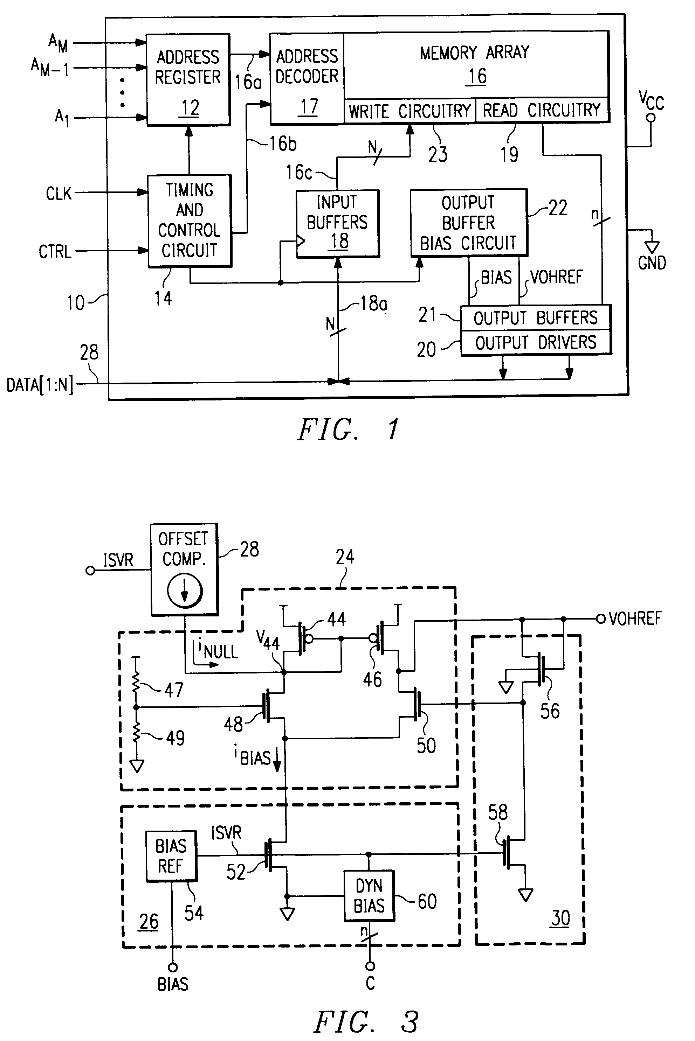

Figure 1 illustrates a block diagram of read/write memory 10 in which the preferred embodiment of the present invention is implemented. Memory 10 includes a plurality of memory cells arranged in memory array 16. In general, memory 10 operates to receive an M bit address and, synchronous to a system clock (denoted "CLK"), to output an N bit data quantity. Integers M and N are selected by the designer according to the desired memory density and data path size. Selected memory cells in memory array 16 are accessed by operation of address register 12, timing and control circuit 14, and address decoder 17, in the conventional manner and as will be described hereinbelow. Data terminals 28 allow for communication of data to and from read/write memory 10; while data terminals 28 in this example are common input/output terminals, it will of course be understood that separate dedicated input terminals and output terminals may alternatively be implemented in memory 10. Data is read from the selected memory cells in memory array 16 via read circuitry 19 (which may include sense amplifiers, buffer circuitry, and the like, as conventional in the art), output buffers 21, and output drivers 20; conversely, data is written to the selected memory cells in memory array 16 via input drivers 18 and write circuitry 17.

Address register 12 includes an integer M number of address inputs labeled $A_1$ through $A_M$. As known in the memory art, the address inputs allow an M bit address to be applied to memory 10 and stored in address register 12. In this example, memory 10 is of the synchronous type, and as such the address value at address inputs A is clocked into address register 12 via CLK, where CLK is passed to address register 12 from timing and control circuit 14. Once the address is stored, address register 12 applies the address to memory array 16 via address decoder 17, in the usual manner. Timing and control circuit 14 is also illustrated as having a generalized set of control inputs (denoted "CTRL") which is intended to represent various control and/or timing signals known in the art, such as read/write enable, output enable, burst mode enable, chip enable, and the like.

In this example, memory 10 receives electrical power from power supply terminal $V_{cc}$, and also has a reference voltage terminal GND. According to the preferred embodiment of the invention, memory 10 will be presenting output data at data terminals 28 for receipt by another integrated circuit that is powered by a power supply voltage lower than that applied to terminal $V_{cc}$ of memory 10. For example, the power supply voltage applied to terminal $V_{cc}$ of memory 10 may nominally be 5 volts (relative to the voltage at terminal GND) while an integrated circuit receiving data presented by memory 10 at terminals 28 may have a power supply voltage of nominally 3.3 volts. In order to allow this condition, the maximum voltage driven by output drivers 20 of memory 10 at data terminals 28 must be at or near this lower power supply voltage (i.e., at or near 3.3 volts), to avoid damage to the downstream integrated circuit. As will be described in detail hereinbelow, the preferred embodiment of the present invention is intended to provide such limitation on the maximum output high level voltage driven by output drivers 20 of memory 10.

Memory array 16 is a standard memory storage array sized and constructed according to the desired density and architecture. In general, array 16 receives decoded address signals from address decoder 17, responsive to which the desired one or more memory cells are accessed. One of the control signals, as noted above, selects whether a read or write operation is to be performed. In a write operation, input data presented to data terminals 28, and communicated via input buffers 18, are presented to the selected memory cells by write circuitry 21. Conversely, in a read operation, data stored in the selected memory cells are presented by read circuitry 19 to output buffers 21. Output buffers 21 then produce control signals to output drivers 20, to present digital output data signals at data terminals 28. In either case, internal operation of memory 10 is controlled by timing and control circuitry 14, in the conventional manner.

According to the preferred embodiment of the invention, memory 10 further includes output buffer bias circuit 22. Output buffer bias circuit 22 generates a bias voltage on line VOHREF that is presented to output buffers 21 so that the control signals presented by output buffers 21 in turn limit the maximum output voltage driven by output drivers 20 on data terminals 28; output buffer bias circuit 22 also generates a voltage on line BIAS that is also presented to output buffers 21, for control of the pull-down slew rate, as will be described hereinbelow. As indicated in Figure 1, and as will be described in further detail hereinbelow, output buffer bias circuit 22 according to the preferred embodiment of the invention is controlled by timing and control circuitry 14 according to the timing of the memory access cycle.

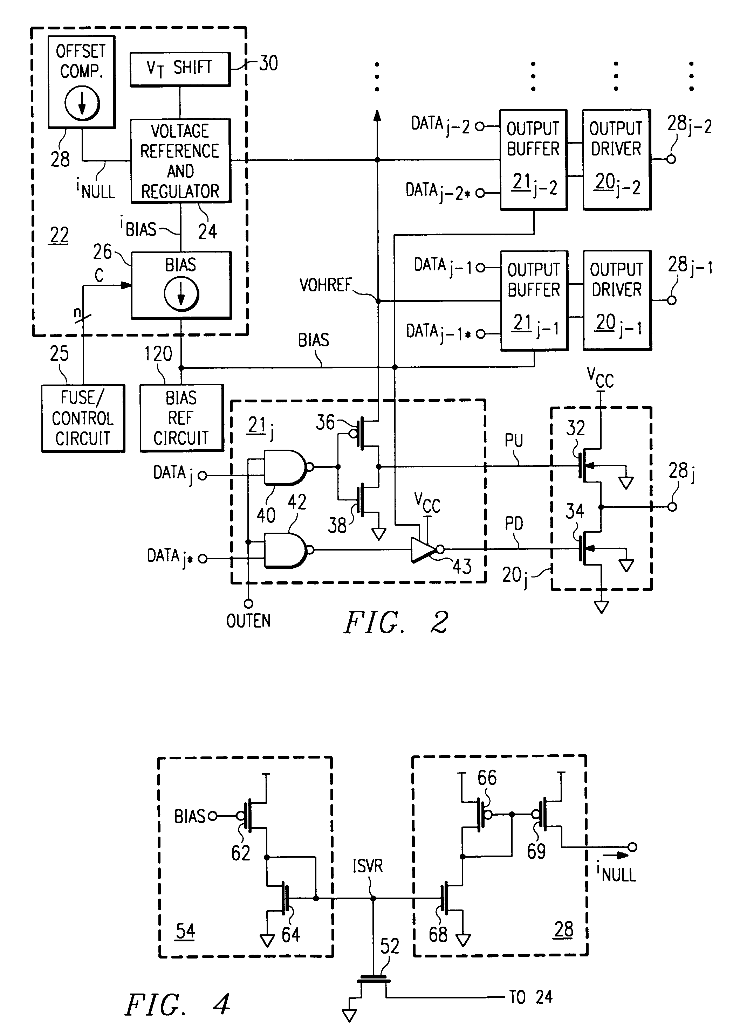

Referring now to Figure 2, the construction of output buffer bias circuit 22 and its cooperation with output buffers 21 and output drivers 20 according to the preferred embodiment of the present invention will be described in further detail. As shown in Figure 2, output buffer bias circuit 22 includes voltage reference and regulator 24, which produces a regulated voltage VOHREF at its output. Output buffer bias circuit 22 further includes bias current source 26 which, as will be described in further detail hereinbelow, is controlled by control signals on bus C from fuse or control circuit 25, which in this embodiment of the invention is preferably contained within timing and control circuitry 14 of Figure 1; as will be described in detail hereinbelow, control signals on bus C may be generated according to the state of programmable fuses, or alternatively may be generated as control signals from a configuration register or based upon external signals.

Bias current source 26 produces a bias current $i_{BIAS}$ used by voltage reference and regulator 24 in generating the voltage on line VOHREF. According to this embodiment of the invention, the bias current $i_{BIAS}$ is controlled responsive to a bias reference voltage generated by bias circuit 120 on line BIAS, as well as according to the control signals on bus C. Also according to this embodiment of the invention, voltage reference and regulator 24 receives an offset compensating current $i_{NULL}$ from offset compensating current source 28. Output buffer bias circuit 22 further includes $V_t$ shift circuit 30, which serves to set the voltage VOHREF. The detailed construction and operation of output buffer bias circuit 22 and its respective constituent blocks will be described in further detail hereinbelow.

Voltage VOHREF is presented to each of the output buffers 21. As such, output buffer bias circuit 22 serves multiple ones of output buffers 21; in many cases, depending upon the number of output buffers 21, a single output buffer bias circuit 22 may suffice to control all of the output buffers 21. Each output buffer 21 receives complementary data inputs DATA, DATA*, which are generated by read circuitry 19 (see Figure 1). For example, output buffer $21_j$ receives complementary data inputs $DATA_j$, $DATA_j$* (the * indicating logical complement). Each output buffer 21 presents control signals (shown as PU and PD for output buffer $21_j$) to a corresponding output driver 20. Each output driver 20 drives a corresponding data terminal 28. While, as shown in Figure 1, data terminals are common input/output terminals, the input side (i.e., data input buffers, etc.) are not shown in Figure 2 for the sake of clarity.

Each output buffer 21 in this embodiment of the invention is implemented as an n-channel push-pull driver. Referring specifically to output driver $20_j$, which is shown in detail in Figure 2 (it being understood that the other output drivers 20 are similarly constructed), n-channel pull-up transistor 32 has its drain biased to $V_{cc}$ and its source connected to data terminal $28_j$, and n-channel pull-down transistor 34 has its drain connected to data terminal $28_j$ and its source biased to ground. Output drivers 20 also preferably include electrostatic discharge protection devices (not shown), as is conventional in the art. The gates of transistors 32, 34 receive control signals PU, PD, respectively, from output buffer 21. As will be appreciated by those of ordinary skill in the art, since $V_{cc}$ (nominally 5 volts, for example) biases the drain of pull-up transistor 32, the voltage of line PU applied to the gate of transistor 32 must be properly controlled to ensure that the maximum voltage to which transistor 32 drives data terminal $28_j$ in presenting a logical one (referred to as $V_{OH}$ maximum) does not exceed the limit (e.g., 3.3 volts). The way in which this limitation is accomplished according to the preferred embodiment of the invention will be described hereinbelow.

As is shown in Figure 2, the body node of n-channel pull-up transistor 32 is preferably biased to ground, rather than to its source at data terminal $28_j$. It will be appreciated by those of ordinary skill in the art that this body node bias for n-channel pull-up transistor 32 is preferred to avoid vulnerability to latchup. However, as will also be appreciated, this bias condition for transistor 32 will effectively increase its threshold voltage, making it more difficult to limit $V_{OH}$ maximum driven by output driver 20. This difficulty is due to the higher voltage to which line PU must be driven in order to turn on transistor 32. The preferred embodiment of the present invention, as will be described hereinbelow, addresses this difficulty in such a way as to allow the body node of transistor 32 to be back biased (i.e., to a voltage other than that of its source).

Output buffer

The construction of output buffer $21_j$ as shown in Figure 2 will now be described in detail, it being understood that the other output buffers 21 are similarly constructed. Output buffer $21_j$ receives the data input lines $DATA_j$, $DATA_j$* at an input of respective NAND functions 40, 42. Output enable line OUTEN is also received at an input of each of NAND functions 40, 42 to perform an output enable function as will be described hereinbelow.

The output of NAND function is applied to the gates of p-channel transistor 36 and n-channel transistor 38. P-channel transistor 36 has its source biased to the voltage VOHREF generated by output buffer bias circuit 22, and has its drain connected to line PU. N-channel transistor 38 has its drain connected to line PU and its source biased to ground. As such, transistors 36, 38 form a conventional CMOS inverter for driving line PU with the logical complement of the logic signal presented by NAND function 40. However, the high voltage to which line PU is driven by transistor 36 is limited to the voltage VOHREF generated by output buffer bias circuit 22. Since line PU is presented to the gate of n-channel pull-up transistor 32 in output driver 20$_j$, the voltage VOHREF thus will control the maximum drive of pull-up transistor 32, and thus the voltage to which data terminal 28$_j$ is driven.

On the low side, the output of NAND function 42 is applied to the input of inverting buffer 43 (which, in this case, is biased by V$_{cc}$). The output of inverting buffer 43 drives line PD, which is applied to the gate of n-channel pull-down transistor 34. As described in further detail hereinbelow, and as described in copending application S.N. 08/357,664 (Attorney's Docket No. 94-C-114), filed December 16, 1994, incorporated herein by this reference, inverting buffer 43 also receives the a reference voltage from bias circuit 120 on line BIAS, and controls the slew rate of its associated output driver 20, primarily by controlling the drive applied to the gate of pull-down transistor 34 on line PD.

In operation, with output enable line OUTEN at a high logic level, the state of NAND functions 40, 42 are controlled by the state of data input lines DATA$_j$, DATA$_j$*, and will be the logical complement of one another (since data input lines DATA$_j$, DATA$_j$* are the logical complement of one another). A high logic level on line DATA$_j$ will thus result in a low logic level at the output of NAND function 40, turning on transistor 36 so that the voltage VOHREF is applied to the gate of transistor 32 via line PU, driving data terminal 28$_j$ to a high logic level (limited by the voltage of VOHREF as noted above); the output of NAND function 42 in this condition is high (data line DATA$_j$* being low) which, after inversion by inverting buffer 43, turns off transistor 34 in output driver 20$_j$. In the other data state, the output of NAND function 40 will be high (data line DATA$_j$ being low), turning on transistor 38 to pull line PU low to turn off transistor 32; the output of NAND function 42 will be low, causing inverting buffer 43 to drive line PD high and turn on transistor 34, pulling data terminal 28$_j$ low; the drive applied to line PD by inverting buffer 43 is controlled by the voltage on line BIAS, thus controlling the slew rate of output driver 20$_j$. With output enable line OUTEN at a low logic level, the outputs of NAND functions 40, 42 are forced high regardless of the data state applied by data input lines DATA$_j$, DATA$_j$*; as a result, transistors 32, 34 are both turned off, maintaining data terminal 28$_j$ in a high impedance state.

As noted above, the voltage on line VOHREF in this embodiment of the invention determines the drive applied to n-channel pull-up transistors 32 in output drivers 20. According to this embodiment of the invention, therefore, the construction of output buffer 21 in providing the voltage VOHREF to the gate of pull-up transistor 32 is particularly beneficial, as it is implemented with a minimum of transistors, and can rapidly switch to effect fast transitions at data terminals 28. In addition, no series devices are required in output drivers 20 to limit V$_{OH}$ maximum according to this embodiment of the invention, such series devices necessarily reducing the switching speed of output drivers 20 and also introducing vulnerability to electrostatic discharge and latchup. Furthermore, no bootstrapping of the gate drive to n-channel transistor 32 is required according to this embodiment of the invention, thus avoiding voltage slew and bump sensitivity.

The construction of output buffer bias circuit 22 in presenting the proper voltage VOHREF, so that memory 10 in this embodiment of the invention may drive a logic high level to a safe maximum level for receipt by integrated circuits having lower power supply voltages will now be described in detail, with respect to each of the circuit functions of output buffer bias circuit 22 shown in Figure 2. Furthermore, the functionality of output buffer bias circuit 22 in generating a voltage on line BIAS, for control of the slew rate of output drivers 20 in switching the outputs from a logic high level to a logic low level, will also be described.

Voltage reference and regulator with V$_t$ shift

Referring now to Figure 3, the construction and operation of voltage reference and regulator 24 will now be described in detail, in cooperation with the other elements of output buffer bias circuit 22.

As shown in Figure 3, voltage reference and regulator 24 is constructed in current mirror fashion. P-channel transistors 44 and 46 each have their sources biased to V$_{cc}$, and have their gates connected together. In the reference leg of this current mirror, the drain of transistor 44 is connected to its gate, and to the drain of n-channel transistor 48. The gate of n-channel transistor 48 is connected to a voltage divider constructed of resistors 47, 49 connected in series between V$_{cc}$ and ground, where the gate of transistor 48 is connected at the point between resistors 47 and 49 to receive the desired fraction (e.g., 60%) of the V$_{cc}$ power supply voltage. Alternatively, each leg of the resistor divider may be constructed of a series of resistors that are initially shorted out by fuses; opening of selected fuses can thus allow programmability of the voltage applied to the gate of transistor 48.

The source of transistor 48 is connected to bias current source 26. In the mirror leg of this current mirror, the drain of transistor 46 is connected, at output node VOHREF, to the drain of n-channel transistor 50. The gate of transistor 50 is coupled to node VOHREF via V$_t$ shift circuit 30, in a manner that will be described in further detail hereinbelow. The source of n-channel transistor 50 is connected to the source of transistor 48 in the reference leg and thus to bias current source 26. As noted above, bias current source 26 conducts a current i$_{BIAS}$, which will be the sum of the currents in the reference and mirror legs in the current mirror of voltage reference and regulator 24 (i.e., the sum of the currents through transistors 48 and 50). The current $i_{BIAS}$ is primarily produced by n-channel transistor 52 which has its drain connected to the sources of transistors 48 and 50, its source biased to ground, and its gate controlled by bias reference circuit 54. As will be further described in detail below, according to the preferred embodiment of the invention, dynamic bias circuit 60 is also provided for controlling the current $i_{BIAS}$ may be decreased at certain times in the memory access cycle (under the control of control bus C), to optimize the output impedance of voltage reference and regulator 24 for different portions of the memory access cycle.

$V_t$ shift circuit 30 provides the bias of the gate of n-channel transistor 50 in the mirror leg of voltage reference and regulator 24 in this preferred embodiment of the invention, to ensure that voltage VOHREF is shifted upward by an n-channel threshold voltage, considering that voltage VOHREF will be applied (via output buffers 21) to the gate of n-channel pull-up transistors 32 in output drivers 21. The way in which this shift is effected will be described hereinbelow with the operation of voltage reference and regulator 24.

The operation of voltage reference and regulator 24 will now be described in detail, at a point in the memory cycle during which output data is to be presented at data terminals 28. Bias reference circuit 54 presents a bias voltage to the gate of n-channel transistor 52 to set the value of $i_{BIAS}$ conducted through the current mirror; dynamic bias circuit 60 is effectively off at this time. The divided voltage generated by resistors 47, 49, which is presented as a reference voltage to the gate of n-channel transistor 48, determines the extent to which transistor 48 is conductive, and thus determines the bias condition at the drain of p-channel transistor 44. The current conducted by transistor 44 is mirrored by transistor 46 in the mirror leg, and will thus be a multiple of the current conducted by transistor 44 (as will be discussed hereinbelow).

The voltage VOHREF at the drains of transistors 46, 50 will be determined by the voltage at the drains of transistors 44, 48, by the relative sizes of the transistors in the circuit, and by the effect of $V_t$ shift circuit 30. As is well known in the art of current mirror circuits, the gate voltage of transistor 50 will tend to match that at the gate of transistor 48, due to the feedback of the voltage at line VOHREF to the gate of transistor 50, considering the differential amplifier effect of voltage reference and regulator 24. $V_t$ shift circuit 30, however, includes transistor 56, connected in diode fashion with its gate connected to its drain at VOHREF, and with its source connected to the gate of transistor 50, so that a threshold voltage drop is present between line VOHREF and the gate of transistor 50. Transistor 56 is constructed similarly as one of n-channel pull-up transistors 32 in output drivers 20, particularly in having the same or similar gate length and in having the same body node bias (e.g., to ground). N-channel transistor 58 has its drain connected to the source of transistor 56, and has its gate controlled by bias reference circuit 54, to ensure proper current conduction through transistor 56 so that an accurate threshold voltage drop is present across transistor 56.

As a result of $V_t$ shift circuit 30, the voltage at line VOHREF will be boosted from the reference voltage at the gate of transistor 48 by a threshold voltage value that closely matches the threshold voltage of the n-channel pull-up transistor 32 of output drivers 20. This additional threshold voltage shift is necessary considering that the voltage VOHREF will be applied to the gate of an n-channel pull-up transistor 32 in output drivers 20, thus ensuring adequate high level drive. The $V_t$ shift is effected by circuit 30 in a way that does not increase the output impedance of voltage reference and regulator 24, particularly in the impedance to sink current through transistor 50 in the event of fluctuations of voltage VOHREF caused by switching output buffers 21. The implementation of circuit 30 also introduces minimum offset voltage into voltage reference and voltage regulator 24, and requires only two additional transistors 56, 58 without adding an entire stage.

It is of course contemplated that the voltage generated on line VOHREF by voltage reference and regulator 24 may be applied to control the logic level high drive of output driver 20 in alternative ways to that described hereinabove relative to the preferred approach of controlling the source voltage of pull-up transistors 36 in output buffers 21. For example, the voltage generated on line VOHREF may be directly applied to the gate of a transistor in series with the pull-up transistor in output driver 20 or, in another example, the voltage generated on line VOHREF may be applied to the gate of a transistor in series with the pull-up transistor in output buffer 21; in each of these alternative cases, the reference voltage on line VOHREF limits the drive applied to the output terminal. In such alternatives, however, one of ordinary skill in the art will recognize that the absolute level of the reference voltage on line VOHREF may have to be shifted from that utilized in the foregoing description.

Offset compensating current source

It is desirable for voltage reference and regulator 24 to have extremely low output impedance, so that substantial current may be sourced to or sinked from line VOHREF without significant modulation of the voltage on line VOHREF. As noted above, since the voltage on line VOHREF controls the maximum output high level voltage $V_{OH}$ maximum so as not to damage an integrated circuit receiving the output logic signals at data terminals 28 while still providing the maximum output drive, it is important that the voltage on line VOHREF remain steady near the regulated level.

In voltage reference and regulator 24, therefore, it is desirable that the drive capabilities, and thus the transistor sizes (i.e., ratio of channel width to channel length, or W/L) of transistors 46 and 50 be quite large. This large size for transistors 46, 50 will allow voltage reference and regulator 24 to rapidly source current (from $V_{cc}$ through transistor 46 to line VOHREF) or sink current (from line VOHREF through transistors 50, 52 to ground). For example, the W/L of transistor 46 may be on the order of 1200, the W/L of transistor 50 may be on the order of 600, and the W/L of transistor 48, in this example, may be on the order of 300. In addition, it is desirable that the W/L of transistor 46 be larger than that of transistor 44, so that a sizable mirror ratio may be obtained, thus increasing the source current available on line VOHREF; further, it is desirable that the W/L of transistor 48 be significantly larger than that of transistor 44, for high gain. In the above example, the W/L of transistor 44 may be on the order of 60, in which case the mirror ratio of voltage reference and regulator 24 would be on the order of 20. The maximum source current $i_{source\ max}$ will be determined as follows:

$$i_{source\ max} = i_{BIAS} \frac{(\frac{W}{L})_{46}}{(\frac{W}{L})_{44}}$$

In the above example, the maximum source current $i_{source\ max}$ will be on the order of 20 times $i_{BIAS}$. The maximum sink current of voltage reference and regulator 24 will be equal to $i_{BIAS}$, which is controlled by bias current source 26. In this embodiment of the invention, it will of course be appreciated that the source current will be the more critical parameter for this embodiment of the invention, as it controls the turn-on of pull-up transistors 32 in output drivers 21.

However, since the currents through the reference and mirror legs of voltage reference and regulator 24 are not equal to one another, an offset voltage can develop between the nodes at the drains of transistors 44, 48, on one hand, and the drains of transistors 46, 50, on the other hand. This offset voltage can be on the order of 300 to 400 mV, and will increase with increasing $i_{BIAS}$.

Furthermore, since the W/L of transistor 48 is substantially larger than that of transistor 44 and due to the diode configuration of transistors 44 (gate tied to drain), transistor 44 is unable to rapidly pull the voltage at the drain of transistor 48 (and the gates of transistors 44, 46) high when necessary. For example, when multiple ones of output drivers 21 simultaneous switch on their respective pull-up transistors 32, substantial source current from voltage reference and regulator 24 is required to maintain the voltage on line VOHREF at the proper level. This source current tends to initially pull down the voltage on line VOHREF, which in turn will pull down the voltage at the drains of transistors 44, 48 in the reference leg of voltage reference and regulator 24, since transistor 48 will be required to temporarily supply most of the current $i_{BULK}$ required by current source 26 because virtually all of the current conducted by transistor 46 is directed to line VOHREF. However, because of its relatively small size (for high mirror ratio), transistor 44 is unable to rapidly pull up the voltage at its drain by itself; if this voltage remains low, once the transient demand for source current is over, the voltage VOHREF will overshoot its steady state voltage, because transistors 44 and 46 will be turned on strongly by the low voltage at their gates. As discussed above, overshoot of the voltage VOHREF can damage downstream integrated circuits that have lower power supply voltages.

According to the preferred embodiment of the invention, therefore, offset compensating current source 28 is provided, to source current $i_{NULL}$ into voltage reference and regulator 24 at the drains of transistors 44, 48. The size of bias current source transistor 52 must therefore be adequate to conduct the additional current $i_{NULL}$ that will be provided into the reference leg of voltage reference and regulator 24 beyond the current mirror; of course, an additional transistor may be provided in parallel with transistor 52 to conduct this additional current. The current $i_{NULL}$ is intended to equate the current per unit channel width conducted by transistor 48 with the current per unit channel width conducted by transistor 50, so that no offset voltage results, as well as easing the load of transistor 48 on transistor 44, and allowing the voltage at the drains of transistors 44 and 48, and thus at the gates of transistors 44, 46, to be rapidly pulled high when necessary. Overshoot of the voltage on line VOHREF is thus prevented.

Referring now to Figure 4, the construction of offset compensating current source 28 will be described in detail. In this particular embodiment of the invention, offset compensating current source 28 is controlled by bias reference circuit 54 in bias current source 26 to minimize the number of transistors required for implementation; of course, offset compensating current source may have its own bias reference network, if desired.

Bias reference circuit 54 is implemented by way of p-channel transistor 62 having its source biased to $V_{cc}$ and its gate biased by a reference voltage BIAS generated by bias circuit 120 described hereinbelow. N-channel transistor 64 is connected in diode fashion, with its gate and drain connected to the drain of transistor 64. The sizes of transistors 62 and 64 are selected to ensure that p-channel transistor 62 remains in saturation for the specified voltage BIAS. For example, for a voltage BIAS of approximately 2 volts, transistors 62 and 64 with W/L ratios of approximately 15 will maintain transistor 62 in saturation where $V_{cc}$ is nominally 5 volts. The common node at the drains of transistors 62, 64 presents a reference voltage ISVR that is applied to the gate of transistor 52 in bias current source 26, and to offset compensating current source 28.

Because of the large currents conducted in voltage reference and regulator 24, as well as the large variations in process parameters and power supply voltages expected over temperature, it is desirable that the operation of bias reference circuit 54 be as stable as possible. The construction of bias reference circuit 54 shown in Figure 4 provides such stability, particularly where bias circuit 120 is constructed to track variations in the $V_{cc}$

power supply voltage and in process parameters, as will be described hereinbelow. In this example, simulation results indicate that the ratio of maximum to minimum current conducted by transistor 52 in bias current source 26, using bias reference circuit 54 to set the gate voltage at node ISVR, over variations in temperature, process parameters, and power supply voltage, is approximately 1.17.

Offset compensating current source 28 according to this embodiment of the invention is implemented by a current mirror circuit, in which the reference leg includes p-channel transistor 66 and n-channel transistor 68. The sources of transistors 66, 68 are biased to $V_{cc}$ and ground, respectively, and their drains are connected together. The gate of n-channel transistor 68 receives the reference voltage at node ISVR from bias reference circuit 54, and the gate of p-channel transistor 66 is connected to the common drain node of transistors 66, 68, and to the gate of p-channel transistor 69 in the mirror leg, in typical current mirror fashion. Transistor 69 has its source biased to $V_{cc}$, such that its drain current provides the current $i_{NULL}$. The relative sizes of transistors 66, 69 will, of course, determine the mirror ratio, and thus the current $i_{NULL}$; a mirror ratio of on the order of 5 will be typical, to produce a current $i_{NULL}$ of on the order of 2.5 mA. As noted above, enough current capability must be provided for transistor 52 to conduct this additional current $i_{NULL}$; preferably, an n-channel transistor is provided in parallel with transistor 52, with its gate controlled by line ISVR, and having a size matching that of the mirror circuit of transistors 66, 68, 69, to conduct the additional $i_{NULL}$ current in a matched fashion.

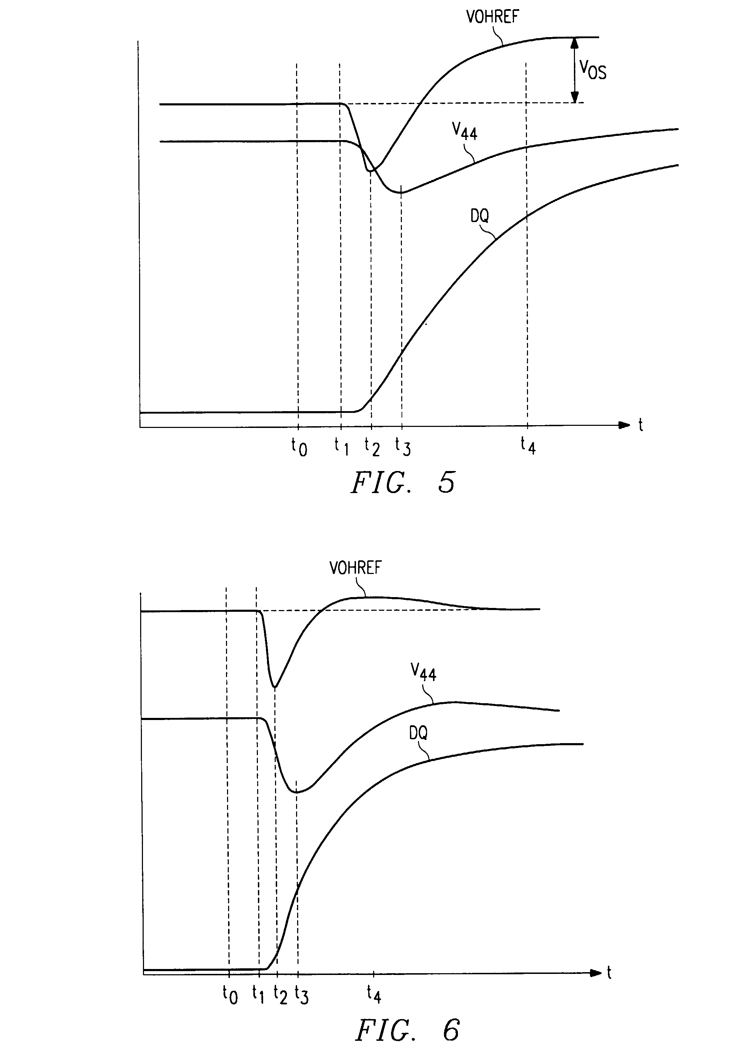

Referring now to Figures 5 and 6, the effect of offset compensating current source 28 on the operation of voltage reference and regulator 24 will now be described, based on simulations. Figure 5 illustrates the operation of voltage reference and regulator 24, in the case where the current $i_{NULL}$ is zero, in other words, as if offset compensating current source 28 were not present. Figure 5 illustrates the voltage VOHREF at the output of voltage reference and regulator 24, the voltage $V_{44}$ at the common drain node of transistors 44, 48, and the output voltage DQ on one of data terminals 28. Time $t_0$ indicates the steady-state condition of these voltages, in the case where all data terminals 28 are driving a low output voltage. In the steady-state, for example, the voltage VOHREF is preferably at 3.3 volts (the lower power supply voltage of an integrated circuit receiving the output data from memory 10) plus an n-channel threshold voltage (considering that pull-up transistor 32 in output driver 20 is an n-channel device). At time $t_1$, data terminals 28 begin switching to a new data state; in this example, the worst case condition is that where all (e.g., eighteen) data terminals 28 are to switch from a low logic level to a high logic level. As shown in Figure 5, once this switching begins as indicated by the voltage DQ begins rising, the voltages VOHREF and $V_{44}$ dip, due to the significant source current required by output buffers 21 on line VOHREF which pulls its voltage down. The voltage $V_{44}$ also drops at this time, since the current through transistor 50 is reduced to near zero (all of the current in the mirror leg being required by output buffers 21), forcing transistor 48 to conduct virtually all of the current $i_{BIAS}$. This additional conduction by transistor 48 in turn drops the voltage at node $V_{44}$. Time $t_2$ indicates the end of the output transient, such that the source current demand begins decreasing, allowing the voltage on line VOHREF to rise by operation of voltage reference and regulator 24. However, as noted above, because of the small size and diode configuration of transistor 44 required for the mirror ratio to be large enough to provide the source current required by output buffers 21, the voltage at node $V_{44}$ remains low for a significant time, and does not begin to rise (slowly) until time $t_3$. So long as the voltage at node $V_{44}$ remains below its steady-state value, which maintains transistors 44 and 46 turned on strongly, the voltage at line VOHREF is allowed to rise, and indeed rises past its steady-state value by a significant margin ($V_{OS}$). This rise in VOHREF past its desired value may then be reflected via output buffers 21 and output drivers 20 onto data terminals 28, indeed to the extent as to cause damage to a lower power supply integrated circuit connected to data terminals 28.

Referring now to Figure 6, the operation of voltage reference and regulator 24 for the example where the current $i_{NULL}$ is 2.5 mA is illustrated, based on simulation of the same conditions as that shown in Figure 5, and having the same time scale as Figure 5. As before, the switching occurring at time $t_1$ causes the voltages VOHREF and $V_{44}$ to drop. However, the additional current $i_{NULL}$ applied to the common drain node of transistors 44, 46 assists in the charging of this node, and as a result the time $t_3$ at which voltage $V_{44}$ begins to rise occurs much sooner after the initial switching time $t_1$. Since the voltage $V_{44}$ begins to rise so quickly in this case, the voltage VOHREF is not allowed to overshoot its steady-state value by nearly as much, nor for nearly as long a time, as in the case of Figure 5 with $i_{NULL} = 0$. Damage to low power supply integrated circuits connected to data terminals 28 is thus avoided.

Programmable compensating bias circuit

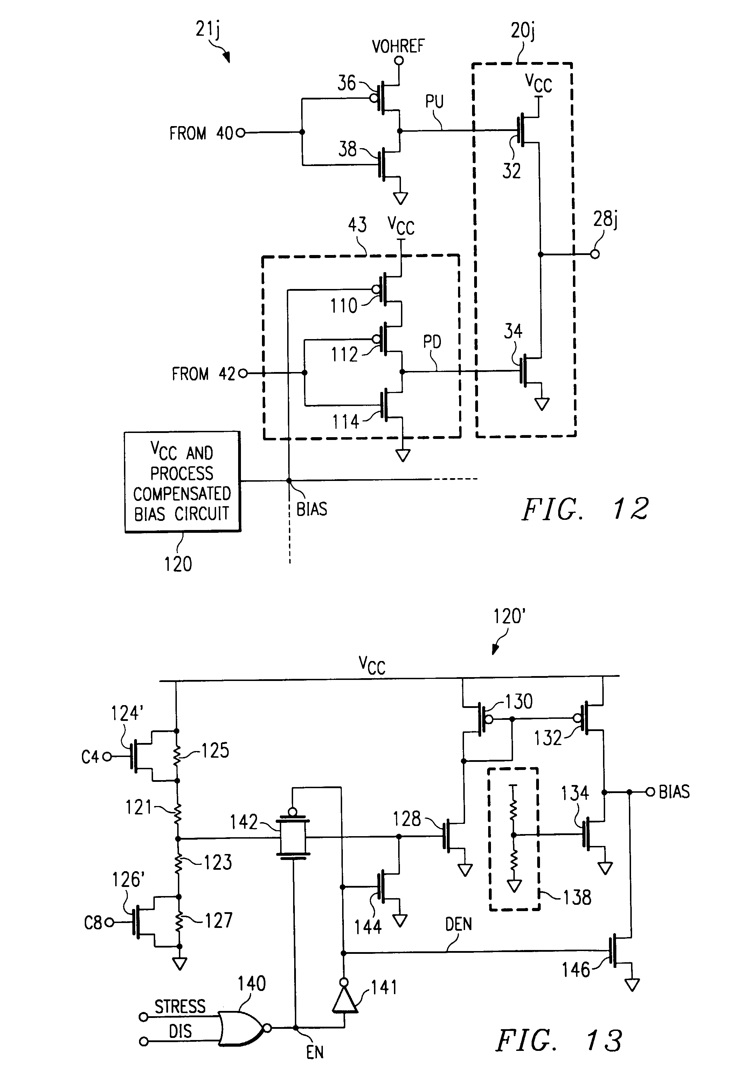

As noted above, the current $i_{BIAS}$ generated by bias current source 26 depends upon the voltage on line BIAS generated by bias circuit 120, as does the output slew rate controlled by inverting buffer 43 in output buffers 21. In addition, as will become apparent from the following description, other functions, such as the output impedance of voltage reference and regulator 24 are also controlled according to the voltage on line BIAS. Referring now to Figure 11, the construction and operation of bias circuit 120 according to the preferred embodiment of the invention will now be described in detail; copending application S.N. 08/357,664 (Attorney's Docket No. 94-C-114), filed December 16, 1994, incorporated herein by this reference, and assigned to SGS-Thomson Microelectronics, Inc., also provides description of bias circuit 120 according to this embodiment of the invention.

Bias circuit 120 is a current mirror bias circuit, in which the reference leg of a current mirror is controlled by a voltage divider. As will be evident from the description hereinbelow, bias circuit 120 provides a bias voltage on line BIAS that varies in a consistent manner with variations in the value of power supply voltage $V_{cc}$, and with variations in certain manufacturing process parameters.

As described hereinabove relative to Figure 4, bias circuit 120 provides a voltage on line BIAS to the gate of p-channel transistor 62 in bias reference circuit 54. It is desired in this example that the gate-to-source voltage of p-channel transistor 62 remain substantially constant over variations in the voltage of the $V_{cc}$ power supply, so that the current therethrough remains constant; in other words, it is desired that the voltage on line BIAS follow variations in $V_{cc}$. In this way, the current through transistor 62 of bias reference circuit 54 will remain substantially constant over such variations.

In this embodiment of the invention, bias circuit 120 includes a resistor divider having resistors 121, 123 connected in series between the $V_{cc}$ power supply and ground. As shown in Figure 11, additional resistors 125, 127 are also present in the voltage divider, with fuses 124, 126 connected in parallel therewith, respectively. The output of the resistor divider 10, at the node between resistors 121, 123, is presented to the gate of an n-channel transistor 128; this voltage will, of course, be a fraction of the $V_{cc}$ power supply voltage, determined by the ratio of the sum of the resistances of resistors 123, 127 to the sum of all resistors 121, 123, 125, 1257, to the extent that resistors 125, 127 are not shorted out by intact fuses 124, 126, respectively.

According to this embodiment of the invention, resistors 121, 123, 125, 127 are preferably implemented as polysilicon resistors, and have varying resistance values among one another. For example, resistors 125a, 125b, 125c may have values that correspond to powers of two among one another (e.g., resistor 125a having twice the resistance of resistor 125b, which in turn has twice the resistance of resistor 125c); the value of resistor 121 may be somewhat larger than even resistor 125a. Such relationships among the resistor values allow for a high degree of tuning of the desired fraction of the $V_{cc}$ power supply voltage by the opening of selected ones of fuses 124, 126. Because of this fuse programmability, the integrated circuit into which bias circuit 120 is implemented allows adjustment of the voltage applied to the gate of transistor 128, to a desired level.

Alternatively, rather than fuses 124, 126, shorting transistors may be implemented across each of resistors 125, 127, with their gates controlled by a control signal from bus C. Use of shorting transistors thus will allow the programmability of the desired fraction of the

$V_{cc}$ power supply voltage to be applied to transistor 128 in a non-permanent manner, for example under the control of the user of the integrated circuit either prior to or after installation of the circuit into a system.

As indicated above, the gate of transistor 128 receives the output of the voltage divider of resistors 121, 123, 125, 127. The source of transistor 128 is biased to ground, and the drain of transistor 128 is connected to the drain and gate of p-channel transistor 130, which in turn has its source tied to $V_{cc}$. The combination of transistors 128, 130 establishes a reference leg of a current mirror, with the current conducted therethrough substantially controlled by the voltage output of the resistor divider of resistors 121, 123, 125, 127. Accordingly, the voltage applied to the gate of transistor 128, and thus the current conducted by transistors 128, 130 in the reference leg of the current mirror, will vary with variations in the voltage of the $V_{cc}$ power supply so as to remain at approximately the same fraction of the voltage of the $V_{cc}$ power supply.

The output leg of bias circuit 120 includes p-channel mirror transistor 132 and linear load device 134. P-channel transistor 132 has its source connected to $V_{cc}$ and its gate connected to the gate and drain of transistor 130, in current mirror fashion. The drain of transistor 132 is connected to the linear load device 134, and drives line BIAS. Load device 134 may be implemented as an n-channel transistor 134, having its source at ground and its gate at $V_{cc}$, in which case the common drain node of transistors 132, 134 drives the bias voltage output on line BIAS. Alternatively, linear load device 134 may be implemented as a precision resistor, or as a two-terminal diode.

In any case, linear load device 134 is important in providing compensation for variations in process parameters, such as channel length. Variations in the channel length of transistors 130, 132 will cause variations in the current conducted by transistor 132 and thus, due to the linear nature of load device 134, will cause a corresponding variation in the voltage on line BIAS. Accordingly, bias circuit 120 provides an output voltage on line BIAS that tracks variations in process parameters affecting current conduction by transistors in the integrated circuit.

As noted above, the current conducted by transistor 132 is controlled to match, or to be a specified multiple of, the current conducted through transistor 130. Since the current conducted through transistors 128, 130 is controlled according to the divided-down voltage of the $V_{cc}$ power supply, the current conducted by transistor 132 (and thus the voltage on line BIAS) is therefore controlled by the $V_{cc}$ power supply. The voltage on line BIAS will thus also track modulation in the $V_{cc}$ power supply voltage by modulating the voltage drop across linear load 134.

Certain sizing relationships among the transistors in bias circuit 120 are believed to be quite important in ensuring proper compensation. Firstly, transistor 128 is preferably near, but not at, the minimum channel length and channel width for the manufacturing process used. By transistor 128 having a channel length near the process minimum, the current conducted by transistor 128 will vary with variations in the channel length for the highest performance transistors in the integrated circuit; use of a longer channel length would reduce the sensitivity of transistor 128 to such variations. However, the channel length of transistor 128 should be slightly larger than minimum, to avoid hot electron effects and short channel effects. Transistor 128 also preferably has a relatively small, but not minimum, channel width, to minimize the current conducted therethrough, especially considering that bias circuit 120 will conduct DC current at all times through transistors 128, 130 (and mirror leg transistor 132 and linear load 134). An example of the size of transistor 128 according to a modern manufacturing process would be a channel length of $0.8\,\mu m$ and a channel width of $4.0\,\mu m$, where the process minimums would be $0.6\,\mu m$ and $1.0\,\mu m$, respectively.

P-channel transistors 130, 132 must also be properly sized in order to properly bias transistor 128 and linear load device 134 (when implemented as a transistor), respectively. For proper compensation of the bias voltage on line BIAS, transistor 128 is preferably biased in the saturation (square law) region, while transistor 134 is biased in the linear (or triode) region. This allows transistor 134 to act effectively as a linear resistive load device, while transistor 128 remains saturated. As is evident from the construction of bias circuit 120 in Figure 2, such biasing depends upon the relative sizes of transistor 128 and 130, and the relative sizes of transistors 132 and 134.

It is preferable for transistor 130 to be as large as practicable so that the voltage at the gate of transistor 128 may be as near to $V_{cc}$ as possible while maintaining transistor 128 in saturation. This is because variations in $V_{cc}$ will be applied to the gate of transistor 128 in the ratio defined by the voltage divider of resistors 121, 123, 125, 127; accordingly, it is preferable that this ratio be as close to unity as possible, while still maintaining transistor 128 in saturation. A large W/L ratio for transistor 130 allows its drain-to-source voltage to be relatively small, thus pulling the drain voltage of transistor 128 higher, which allows the voltage at the gate of transistor 128 to be higher while still maintaining transistor 128 in saturation. The tracking ability of bias circuit 120 is thus improved by transistor 130 being quite large.

In the above example, where the $V_{cc}$ power supply voltage is nominally 5.0 volts, the following table indicates the preferred channel widths (in microns) of transistors 128, 130, 132 land 34 in the arrangement of Figure 11, for the case where the channel length of each is $0.8\,\mu m$:

Table

| Transistor | Channel Width (μm) |
| --- | --- |
| 128 | 4.0 |
| 130 | 32.0 |
| 132 | 76.0 |
| 134 | 4.0 |

It has been observed (through simulation) that this example of bias circuit 120 is effective in maintaining good tracking of the voltage on line BIAS over a relatively wide range of $V_{cc}$ supply voltage. Attention is directed to copending application S.N. 08/357,664 (Attorney's Docket No. 94-C-114), filed December 16, 1994, incorporated herein by this reference, for further description of such tracking.

Dynamic Control of Bias Current

As is evident from the foregoing description, it is desirable that the output impedance of voltage reference and regulator 24 be as low as possible during such times as output buffers 21 and output drivers 20 will be switching the state of data terminals 28. This low output impedance allows for significant source and sink current to be provided by voltage reference and regulator 24, without significant modulation in the voltage VOHREF. However, such low output impedance requires that the DC current through voltage reference and regulator 24 to be significant, thus causing significant steady-state power dissipation and the corresponding increase in temperature, decrease in reliability, and load on system power supplies, all of which are undesirable.

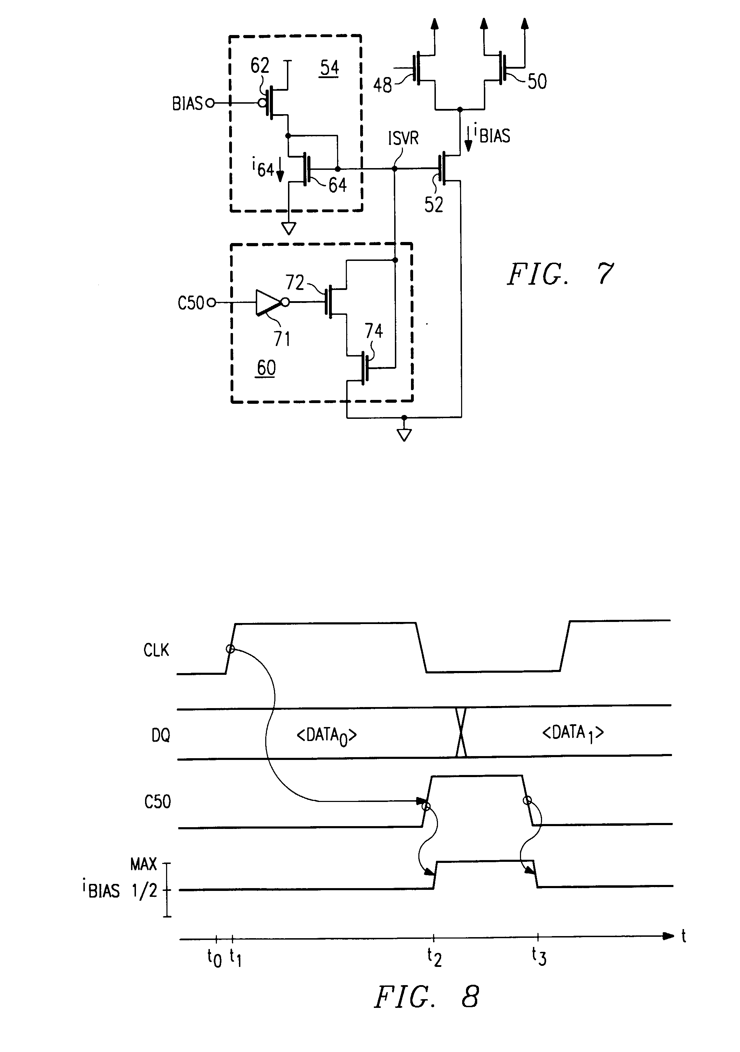

Referring now to Figure 7, the construction and operation of dynamic bias circuit 60, in controlling the bias current $i_{BIAS}$ within a memory access cycle, will now be described in detail. Dynamic bias circuit 60 is provided as an optional function in voltage reference and regulator 24, for purposes of reducing the steady-state current drawn thereby. As shown in Figure 7, dynamic bias circuit 60 receives clock signal C50 (which may be one of the lines of control bus C produced by fuse and control circuit 25) from timing and control circuit 14, and applies it to the gate of n-channel transistor 72 via inverter 71. Transistor 72 has its drain connected to node ISVR at the output of bias reference circuit 54 and at the gate of current source transistor 52. The source of transistor 72 is connected to the drain of n-channel transistor 74, which has its gate connected to node ISVR and it source biased to ground.

In operation, so long as the clock signal C50 remains high, transistor 72 will be off and dynamic bias circuit 60 will not affect the gate bias of transistor 52 nor the value of the current $i_{BIAS}$ conducted thereby. With clock signal C50 low, however, transistor 72 will be turned on and the voltage at the gate of transistor 52 will be reduced due to transistors 72, 74 pulling node ISVR toward ground and reducing the current conducted thereby.

The extent to which the gate bias of transistor 52 is reduced by dynamic bias 60 is determined by the size of transistor 74 relative to the size of transistor 64 in bias reference circuit 54 and relative to the size of transistor 52, as will be apparent to those of ordinary skill in the art. This sizing can be readily determined, considering that the gate-to-source voltage of transistor 74 will be the same as that of transistor 64 in bias reference circuit 54. The drain-to-source voltage of transistor 74 will be less than that of transistor 64, however, by the amount of the drain-to-source voltage of transistor 72 when turned on, which will typically be quite small, for example on the order of 100 mV. With both of transistors 64, 74 in saturation, their drain currents will not be significantly affected by their drain-to-source voltages, and as such transistors 64, 74 may be considered to be in parallel with one another when transistor 72 is turned on. Since the current in transistor 52 mirrors that of transistor 64 (in parallel with transistor 74, when transistor 72 is on), clock signal C50 controls the current $i_{BIAS}$, which effectively changes the current mirror ratio of transistor 64 to transistor 52.

For example, in the case where the current $i_{BIAS}$ is to be reduced to 50% of its full value except during output switching, the channel width and channel length of transistors 64 and 74 will be the same, if the channel width and channel length of transistors 64 and 52 are the same, as in this example. With transistor 72 turned off, the current $i_{BIAS}$ will equal the current $i_{64}$ through transistor 64 in bias reference circuit 54. With transistor 72 turned on (clock signal C50 low), as noted above, transistors 64, and 74 are effectively in parallel with each other and, in this example, have a channel width that is effectively twice that of transistor 52. The current mirror ratio is therefore one-half, since:

$$\frac{W_{52}}{W_{64}+ W_{74}} = \frac{1}{2}$$

where $W_{52}$, $W_{64}$, $W_{74}$ are the channel widths of transistor 52, 64, 74 (channel lengths assumed to be equal). The sum $W_{64} + W_{74}$ is the effective channel width of transistors 64 and 74 in parallel with one another. Accordingly, the current $i_{BIAS}$ is reduced by one-half during such time as clock signal C50 is low.

Referring now to Figure 8, the operation of dynamic bias circuit 60 and its affect on the bias current $i_{BIAS}$ within a memory access cycle will now be described. Time $t_0$ illustrates the condition of memory 10 at the end of a previous cycle, in the steady state. Data terminals DQ are presenting the output data value $DATA_0$ from the prior cycle. Clock C50 is low at this time, since output switching is not occurring. Accordingly, the current $i_{BIAS}$ is at one-half of its maximum value, since transistor 72 (Figure 7) is turned on by inverter 71, placing transistor 74 in parallel with transistor 64 of bias reference circuit 54, and thus reducing the mirror ratio of transistor 52. This reduces the current $i_{BIAS}$ drawn by voltage reference and regulator 24 during times in the memory access cycle in which output switching is not expected, and thus during which only the prior data state (i.e., $DATA_0$) is being maintained. The output impedance of voltage reference and regulator 24 may be relatively high during this time, but the voltage on line VOHREF will be maintained at its correct steady-state level.

At time $t_1$, a new memory access cycle is initiated by input clock CLK going active; alternatively, for example in a fully static memory, clock CLK may correspond to an edge transition detection pulse generated by detection of a transition at address or data input terminals of the memory. Responsive to the leading edge of clock CLK, clock signal C50 is activated after a selected delay corresponding to a time safely short of the minimum expected read access time of the memory. Once clock signal C50 becomes active at time $t_2$, transistor 72 is then turned off by operation of inverter 71. Accordingly, the current mirror ratio of transistor 52 is restored to its maximum value (unity, in this example) prior to such time as the output buffers 21 and output drivers 20 begin driving data terminals 28 to a new data state (i.e., $DATA_1$). After another delay time sufficient to ensure that the new data state $DATA_1$ is stable, clock signal C50 returns low, shown at time $t_3$ of Figure 8. This again turns on transistor 72, reducing $i_{BIAS}$ to 50% of its maximum value, in this example, and thus reducing the DC current drawn through voltage reference and regulator 24.

Adjustable bias current source

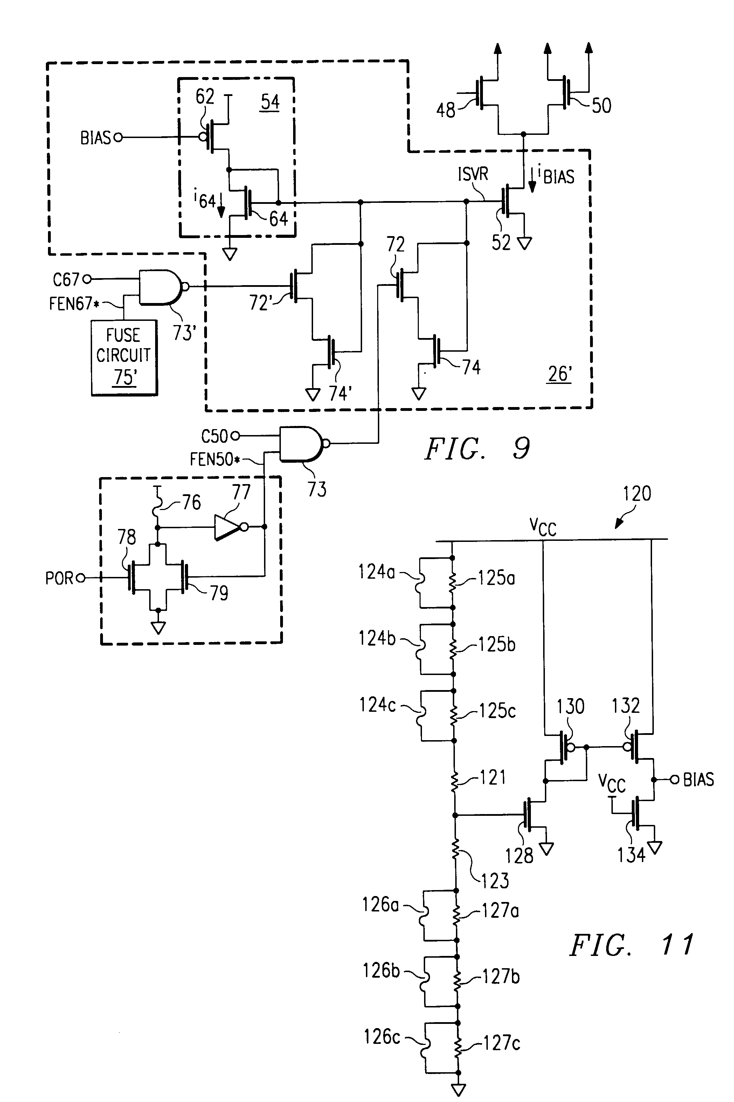

Referring now to Figure 9, bias current source 26' according to an alternative embodiment of the invention will now be described in detail. Bias current source 26' provides for multiple levels of adjustment of the current $i_{BIAS}$ for voltage reference and regulator 24, controllable either by clock signals as in the case of dynamic bias circuit 60 described hereinabove, or by other control signals of control bus C generated by fuse and control circuit 25. As such, by the programming of fuses at a late stage in the manufacturing process, or by the generation of control signals or states by the user, the current $i_{BIAS}$ may be optimized for a particular application, such that the output driver performance may be specifically optimized.

Bias current source 26' incorporates bias reference circuit 54 and current source transistor 52, connected to voltage reference and regulator 24 as before. In addition, as described hereinabove relative to Figure 7, transistors 72 and 74 are provided to reduce the current $i_{BIAS}$ to 50% of its prior value when transistor 72 is turned on. In this case, however, the gate of transistor 72 is controlled by NAND function 73 which receives control signal C50 from control bus C at one input, and which receives the output of fuse circuit 75 on node FEN50* at another input.

Fuse circuit 75 provides for the programmability of the state of transistor 72 in a permanent fashion. Such programmability may be useful in the early stages of the design and manufacture of memory 10, when the optimum value of $i_{BIAS}$ has not yet been determined. In addition, programmability of the value of $i_{BIAS}$ is also desirable if the process variations in the manufacture of memory 10 vary widely enough that the optimum value of $i_{BIAS}$ is preferably set after initial test of the memory 10. For example, if memory 10 is processed to have very short channel widths, the value of $i_{BIAS}$ may be preferably reduced by programming fuse circuit 75 to maintain transistor 72 on at all times.

Furthermore, one may program fuse circuit 75 to select a desired output slew rate for a particular system application. For example, if the integrated circuit is intended for a relatively modest performance application where noise and power dissipation are of high concern, optimization of the circuit would permit a relatively slow output slew rate by raising the output impedance of the circuit; this would reduce the current sourcing ability of pull-up transistors 32 in output drivers 20, thus reducing power dissipation and also the noise generated by the output circuitry according to this embodiment of the invention. Alternatively, if the highest switching speed is desired, regardless of power dissipation and noise concerns, the circuit may be optimized to have the least output impedance, and thus the fastest output slew rate and maximum current sourcing and sinking capability. Other applications may desire an operating point between these extremes, which also may be obtained from the present invention.

The construction of fuse circuit 75 may be accomplished in any one of a number of conventional ways. The example of Figure 9 simply has fuse 76 connected between $V_{cc}$ and the input of inverter 77, which drives node FEN50* from its output. Transistors 78 and 79 have their source/drain paths connected between the input of inverter 77 and ground. The gate of transistor 78 receives a power on reset signal POR, such that transistor 78 pulls the input of inverter 77 to ground upon power up of memory 10. The gate of transistor 78 is connected to the output of inverter 77 at node FEN50*. In operation, with fuse 76 intact, node FEN50* is held low by operation of inverter 77. With fuse 76 open, a pulse on line POR will pull the input of inverter 77 low, driving node FEN50* high, and turning on transistor 78 to maintain this condition.

In operation, the output of NAND function 73 will be high if either control signal C50 or node FEN50* is low. Accordingly, by not blowing fuse 76 open, node FEN50* will be held low, maintaining the output of NAND function 70 high and maintaining transistor 72 on unconditionally. With fuse 76 opened, control signal C50 will control the state of transistor 72 as in the case of Figure 8 described hereinabove.

It is contemplated that the generation of control signal C50 may be done in several ways. For example, fuse and control circuit 25 of Figure 1 may contain a writable register, in which the state of control signal C50 may be set by the system user in a special test or operating mode, such as one enabled by a special overvoltage condition applied to certain terminals of the device; in this way, the output driver performance may be programmed by the system manufacturer in a "permanent" way, once the particular system application for the device is known. Alternatively, the state of control signal C50 may be controlled by an external signal applied to the integrated circuit during use, or by the setting of a register that is writable during normal operation, in which case the output drive characteristics may be adjusted after system installation of the integrated circuit. Still further in the alternative, the state of control signal C50 may be set by the manufacturer by way of a bond wire option, where signal C50 is directly or indirectly controlled by the voltage at a bond pad of the chip that may be connected to either $V_{cc}$ or to ground during bonding.

Of course, it is contemplated that memory 10 may be implemented without control signal C50, such that the state of transistor 72 is dependent solely upon the programmed state of fuse circuit 75. In this way, the integrated circuit manufacturer may set the output driver characteristics at the end of the manufacturing cycle, by a laser programming operation similar to that used to enable redundant memory locations, once the demand for integrated circuits meeting particular device specifications is known. In addition, the integrated circuit manufacturer may program the integrated circuit based on its own performance characteristics. For example, if an integrated circuit has been manufactured to have relatively slow dynamic performance (e.g., high threshold voltages and long transistor channel lengths), the manufacturer may program the output drive characteristics to have relatively slow slew rates, as the integrated circuit may be incapable of meeting high performance specifications anyway; for circuits that have been manufactured under process conditions favoring high performance, however, the manufacturer may program the output drive characteristics to have maximum slew rate and minimum output impedance, to achieve the highest performance. The circuitry of Figure 9 allows for such programming of the output drive characteristics.

Bias current source 26' according to this alternative embodiment of the invention also includes transistors 72', 74' connected in series between node ISVR and ground, in similar fashion as transistors 72, 74 previously described. The gate of transistor 72 is similarly controlled by NAND function 73', responsive to the state of clock signal C67 and to fuse circuit 75' via node FEN67*. However, the size of transistor 74' is selected to be different from that of transistor 74 so that, when transistor 72' is turned on by either clock signal C67 or by fuse circuit 75', the current $i_{BIAS}$ is selected to be at a different fraction of its maximum value. For example, if the channel width of transistor 74' is one-half that of transistor 52 and of transistor 64 in bias reference circuit 54 (assuming the same channel length), then the effective channel width of the parallel combination of transistors 64, 74' will be 1.5 times the channel width of transistor 52. Accordingly, the value of $i_{BIAS}$ with transistor 74' turned on will be two-thirds that of its maximum value with transistor 74' turned off.

Of course, other transistors of varying sizes may be similarly implemented into bias current source 26', if different values of current $i_{BIAS}$ are desired to be permanently programmed, clocked in at specific times of the memory cycle, or placed under system control. In addition, for example, both of transistors 72, 72' may be simultaneously turned on to further reduce the current $i_{BIAS}$. It is contemplated that other combinations of reduction in current will be apparent to those of ordinary skill in the art.

According to this alternative embodiment of the invention, therefore, the value of the bias current $i_{BIAS}$ may be optimized for the particular design, for individual memory circuits depending upon the process parameters as determined by electrical test, or at specific points in time during the memory cycle. This optimization allows optimization of the tradeoff between maximum source and sink current and minimum output impedance for voltage regulator and reference 24, on the one hand, and the current drawn by voltage regulator and reference 24, on the other hand. In addition, the desired output slew rate may be selected by the selection of the desired current mirror ratio.

Variable slew rate control by programmable bias voltage

Referring now to Figure 12, the incorporation of $V_{cc}$ and process compensated bias circuit 20 as described hereinabove, into a output driver circuit, is illustrated. As is evident, the construction of the output buffer $21_j$ and output driver circuit $20_j$ shown in Figure 12 corresponds to that described hereinabove relative to Figure 2, with like elements referred to by the same reference numerals. However, Figure 12 illustrates the detailed construction of the preferred example of inverting buffer 43 in such a manner as to control the slew rate of output driver $20_j$, as will be described hereinbelow.

As shown in Figure 12, the gate of n-channel pull-down transistor 34 is driven from the drains of p-channel transistor 112 and n-channel transistor 114, the gates of which are connected to receive the input data signal from NAND gate 42 (see Figure 2). As such, transistors 112, 114 implement a logical inversion of the logic state of the output of NAND gate 42. The source of transistor 114 is biased to ground, while the source of transistor 112 is connected to the drain of p-channel bias transistor 110, which has its source biased to $V_{cc}$. The gate of p-channel bias transistor 110 is driven by the voltage on line BIAS generated by bias circuit 120. In this arrangement, the current conducted by transistor 110 controls the drive current of transistor 112 when transistor 34 is to be turned on to drive a low logic level at terminal $28_j$.

Accordingly, transistor 110 controls the rate at which the gate of transistor 34 is pulled high responsive to a transition of input data line. The current of transistor 110 thus controls the rate at which pull-down transistor 34 is turned on when output terminal $28_j$ is to be switched from a high logic level to a low logic level. In the example of Figure 12, slew rate control by way of inverting buffer 43 is provided only for n-channel pull-down transistor 34, since the drive of n-channel pull-up transistor is controlled by the voltage on line VOHREF, as well as the output impedance of voltage regulator and reference 24 in driving line VOHREF.

As is well known in the art, inductive noise is generated as a result of the time rate of change of current applied to a load ($dV = L\, di/dt$). Higher switching speed thus generally results in increased noise, since the time rate of change of the current increases. Circuit designers generally select an operating point at an optimized condition, relative to switching speed and noise. In order to maintain this optimized operation, as described above, bias circuit 120 presents a bias voltage on line BIAS that is compensated for variations in power supply voltage and in process variations, thus providing stable output driver operation. Accordingly, the voltage at the gate of transistor 110 in output buffer 21 will follow variations in the $V_{cc}$ power supply voltage (at the source of transistor 110). As a result, the current conducted through transistor 110 in output buffer 21 will remain substantially constant over such variations in the $V_{cc}$ power supply voltage, since its gate-to-source voltage remains constant.

As described hereinabove, according to the preferred embodiment of the invention, the voltage on line BIAS generated by bias circuit 120 may be programmed by opening selected fuses, or by way of control signals on bus C. This programmability of the voltage on line BIAS thus allows for selection of the slew rate at which transistor 34 in output drivers 20 turn on, thus providing further control of the output drive capability of the integrated circuit.

Referring now to Figure 13, bias circuit 120' according to an alternative embodiment of the invention will now be described in detail. Similar elements in circuit 120' as those in circuit 20 described hereinabove will be referred to with the same reference numerals.

Bias circuit 120' is constructed similarly as bias circuit 20 described hereinabove. In this example, however, the gate of linear load transistor 134 is set by voltage divider 138, such that the gate voltage is a specified fraction of the $V_{cc}$ power supply voltage. Transistor 134, while operating substantially as a linear load, is in fact a voltage-controlled resistor, such that its on resistance is a function of the gate-to-source voltage. By applying only a fraction of $V_{cc}$ to the gate of transistor 134, as shown in Figure 13, undesired reduction of the resistance of transistor 134 may be reduced in the event that $V_{cc}$ makes a positive transition.

In addition, as shown in Figure 13, resistors 125, 127 in the voltage divider of bias circuit 120' are in parallel with corresponding shorting transistors 124', 126'. In this example, shorting transistors 124', 126' are of the field-effect type, and have gates controlled by control signals $C_H$, $C_L$, respectively, which are signals from control bus C from fuse and control circuit 25. Bias circuit 120' thus illustrates the use of control signals to set the voltage on line BIAS by selectively switching in and out resistors 125, 127 in the voltage divider of bias circuit 120'. Of course, fuses may be alternatively used in the arrangement of Figure 13, if permanent programmability is desired.

Bias circuit 120' according to this alternative embodiment of the invention also includes circuitry for disabling the slew rate control function when desired. When the bias function is disabled, transistors 110 of output buffers 21 are fully turned on, with a low logic level on line BIAS in this example. As shown in Figure 13, NOR function 140 receives inputs on lines DIS and STRESS, for example. Line DIS is generated elsewhere on the integrated circuit, and presents a high logic level when bias circuit 120' is to be disabled; it is contemplated that line DIS may be dynamically generated so as to be present for particular operations, or alternatively line DIS may be driven by a fuse circuit so that bias circuit 120' is forced to the disabled state by the opening of a fuse in the manufacturing process. Line STRESS presents a high logic level during a special test mode, such as when extraordinarily high voltages are presented to certain nodes in the integrated circuit. Line STRESS is thus generated by a special test mode control circuit, for example responsive to an overvoltage condition, as is well known in the art.

The output of NOR gate 140 thus presents a high logic level signal, on line EN, responsive to neither of lines DIS and STRESS at its inputs being asserted, to enable bias circuit 120'; NOR gate 140 conversely presents a low logic level on line EN responsive to either of the disabling conditions indicated on lines DIS and STRESS. Line EN is directly connected to the n-channel side of pass gate 142, and is connected via inverter 141 to the p-channel side of pass gate 142, so that pass gate 142 is conductive when line EN is high, and open when line EN is low (i.e., when line DEN, at the output of inverter 141, is high). Line DEN is also connected to the gates of n-channel transistors 144 and 146. Transistor 144 has its drain connected to the gate of transistor 128, and transistor 146 has its drain connected to line BIAS; the sources of transistors 144, 146 are connected to ground.

In operation, when line EN is high due to both lines DIS and STRESS being low, pass gate 142 is conductive and transistors 144 and 146 are turned off. The operation of bias circuit 120' in this condition is identical to that of bias circuit 120 described hereinabove, such that line BIAS tracks changes in the $V_{cc}$ power supply voltage so as to control transistor 110 in inverting buffers 43 in a manner to maintain operation at or near the optimized condition, as described hereinabove. When line EN is low and line DEN is high, due to either of lines DIS and STRESS being asserted to a high level, pass gate 142 is turned off. Transistor 144 is turned on by line DEN being high, which turns off transistor 128 by pulling its gate to ground; this inhibits current from being conducted through either of transistors 130, 132. Transistor 146 is also turned on by line DEN being high, pulling line BIAS to ground. Referring back to Figure 12, p-channel transistor 110 is fully turned on by line BIAS being at ground, in which case the slew rate of pull-down transistor 34 is not controlled. Bias circuit 120' according to this alternative embodiment thus allows for the slew rate control function to be selectively disabled.

Variable output $V_{OH}$ control

According to another alternative embodiment of the invention, selectability of the VOHREF limiting function is provided, either by way of a logic signal or by way of fuse programmability. According to this embodiment of the invention, it is contemplated that not all memories of the same design may be specified for use in combination with other integrated circuits using lower power supplies. For example, a subset of the memories may have a $V_{OH}$ maximum of 5.0 volts, while a different subset may have a $V_{OH}$ maximum limited to 3.3 volts. For purposes of manufacturing ease and inventory control, it is preferable to have a single integrated circuit design suitable for use as either, where the decision between 5.0 volt or 3.3 volt $V_{OH}$ maximum may be made at the latest possible stage of the manufacturing process. In addition, the suitability of specific memory chips for 3.3 volt operation may depend on process parameters, such as current drive, such that certain memories may not meet the 3.3 volt operating specification even if the VOHREF limiting function is enabled, but would meet the operating specification for memories with 5.0 volt $V_{OH}$ maximum. In this case, it would be desirable to have selectability of the VOHREF limiting function after electrical test.

Further in the alternative, it may be useful to have a special test mode for memory 10, in which the VOHREF limiting function could be selectively enabled and disabled.

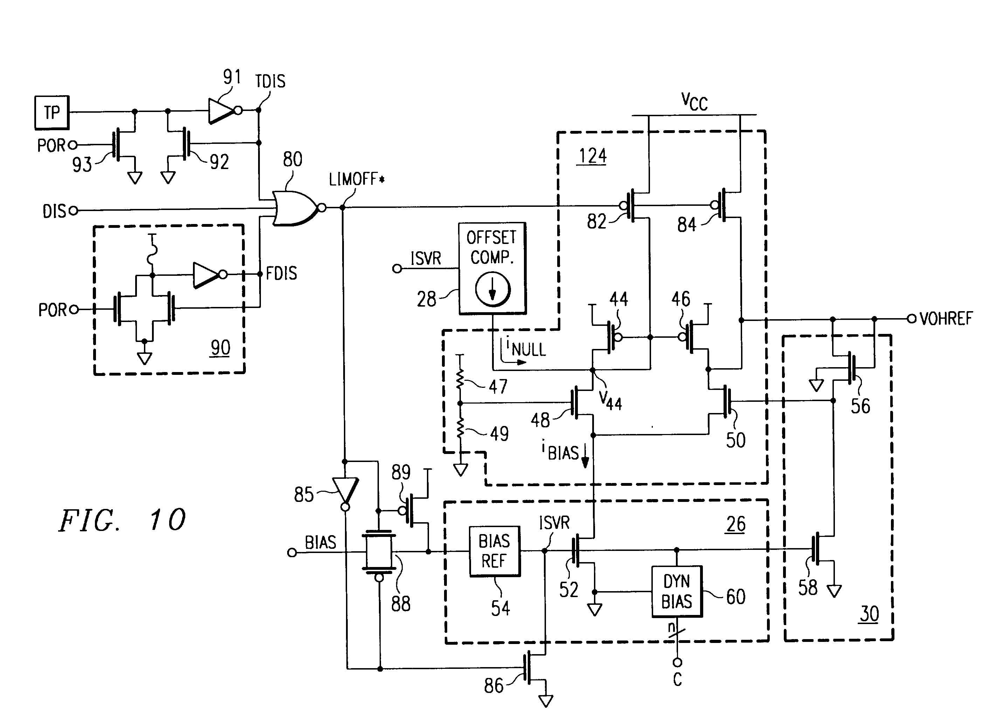

Referring now to Figure 10, an alternative embodiment of the invention is illustrated in which voltage reference and regulator 124 is similarly constructed as voltage reference and regulator 24 described hereinabove, but may be disabled by way of an external signal, a special test mode signal, or programming of a fuse circuit. Those elements common to voltage reference and regulator 24 and voltage reference and regulator 124 are referred to by the same reference numeral, and will not be described again relative to voltage reference and regulator 124 of Figure 10.

In addition to the previously described elements, voltage reference and regulator 124 includes p-channel transistors 82, 84, 89, and n-channel transistor 86, which force certain nodes to $V_{cc}$ or to ground in the event that the VOHREF limiting function is to be disabled, as indicated by the output of NOR gate 80 as will be described hereinbelow. Each of p-channel transistors 82, 84, 89 has its source biased to $V_{cc}$, and its gate receiving line LIMOFF* from the output of NOR gate 80. The drain of transistor 82 is connected to the gates of transistors 44, 46 in the current mirror of voltage reference and regulator 124, the drain of transistor 84 is connected to line VOHREF at the output of voltage reference and regulator 124, and the drain of transistor 89 is connected to the input to bias reference circuit 54. N-channel transistor 86 has its drain connected to node ISVR in bias current source 26, has its source connected to ground, and has its gate receiving signal LIMOFF*, after inversion by inverter 85. According to this embodiment of the invention, pass gate 88 is provided between voltage BIAS and bias reference circuit 54, and is controlled by true and complement signals based on the signal LIMOFF*.

In operation, if line LIMOFF* at the output of NOR function 80 is at a high logic level, transistors 82, 84, 86, 89 are all turned off and pass gate 88 is turned on; in this case, voltage reference and regulator 124 operates to limit the voltage at line VOHREF in the manner described hereinabove for voltage reference and regulator 24.

However, if line LIMOFF* at the output of NOR function 80 is at a low logic level, transistors 82, 84, 86, 89 are all turned on and pass gate 88 is turned off. In this condition, line VOHREF is forced to 5.0 volts, and thus the drain voltage applied to output buffers 21 (and thus applied to the gate of pull-up transistors 32 in output drivers 20) is not limited to a reduced level. In order to minimize DC current drawn through voltage reference and regulator 124, certain nodes therein are also forced to particular voltages. In this example, the gates of transistors 44, 46 are pulled to $V_{cc}$ by transistor 82, thus turning off both of the reference and mirror legs in voltage reference and regulator 124. Pass gate 88 disconnects voltage BIAS from bias reference circuit 54, transistor 89 pulls the input to bias reference circuit 54 to $V_{cc}$, and transistor 86 pulls node ISVR to ground, thus turning off transistors 52 and 58. Of course, the output of NOR function 80 may also be applied to nodes within offset compensating current source 28, bias reference circuit 54, and the like, as desirable.

In this example of the invention, NOR function 80 receives three inputs, any one of which being at a high logic level will cause line LIMOFF* to be driven low. A first input is logic signal DIS, which may be generated elsewhere in memory 10, for example in timing and control circuitry 14; for example, a certain combination of inputs or instructions may be applied to memory 10 such that logic signal DIS is activated. A second input of NOR function 80, on node FDIS, is generated by fuse circuit 90. Fuse circuit 90 is constructed as described hereinabove relative to fuse circuit 75, such that node FDIS is at a low logic level with the fuse intact, and at a high logic level if the fuse is blown.

According to this embodiment of the invention, a special test pad TP can also control the enabling and disabling of voltage reference and regulator 124 during electrical test in wafer form (i.e., prior to packaging). Test pad TP is connected to the input of inverter 91, which drives node TDIS received as an input of NOR function 80. Transistor 92 has its source/drain path connected between the input of inverter 91 and ground, and has its gate connected to node TDIS at the output of inverter 91. Transistor 93 has its source/drain path connected between the input of inverter 91 and ground, and its gate controlled by the power on reset signal POR.

In operation, if test pad TP is held at $V_{cc}$, inverter 91 will force node TDIS low. However, if test pad TP is left open or is connected to ground, upon power up transistor 93 will pull the input of inverter 91 low, forcing a high logic level on node TDIS which is maintained through operation of transistor 92. It is contemplated that test pad TP can thus control the enabling and disabling of voltage reference and regulator 124 during electrical test. Depending upon the result of such testing, test pad TP may be wire-bonded to $V_{cc}$ if voltage reference and regulator 124 is to be permanently enabled, or left open (preferably hard-wired to ground) if voltage reference and regulator 124 is to be permanently disabled for a particular memory 10.

Such selective enabling and disabling of the $V_{OH}$ limiting function of the voltage reference and regulator according to the present invention is contemplated to greatly improve the manufacturing control of integrated circuits incorporating the function. In particular, integrated circuits corresponding to different specification limits may be manufactured from the same design, with selection of the maximum $V_{OH}$ voltage made late in the process, after electrical test. In addition, as noted above, fuse programming may be used to adjust the voltage divider presenting the input voltage to the voltage reference and regulator circuit, allowing additional tuning of the desired maximum $V_{OH}$ voltage.

Conclusion

According to the preferred embodiments of the invention described hereinabove, therefore, optimization of the performance of output driver circuitry is provided in a way that need not be selected in the design process, but may instead be selected late in the manufacturing process, or indeed by the user of the integrated circuit. This optimization is provided by the ability to program, either permanently or temporarily, the output impedance of a circuit that provides a reference drive voltage to an output buffer, by selecting a current mirror ratio therein. Such optimization is also provided by programmability of a reference voltage controlling the slew rate of the output buffer. As a result, optimal device performance for a specific implementation may be obtained, without complicating the inventory control for the integrated circuit manufacturer or for the system manufacturer.

Of course, it is contemplated that various alternatives of the above-described embodiments will also provide the benefits of the present invention. For example, while a single bias circuit 120 is shown as both providing a bias voltage to voltage reference and regulator 24 and for generating a voltage for controlling the slew rate of the output driver, it is of course contemplated that separate bias circuits may be provided for these functions, particularly if programming of the bias voltage is to be selected for one such function but not the other. Other alternatives will, of course, be apparent to one of ordinary skill in the art having reference to this specification.

While the invention has been described herein relative to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. An output driver circuit for driving an output node responsive to a data signal received at a data node, comprising:

   a first drive transistor, having a conduction path connected between the output node and a first power supply voltage, and having a control terminal;

   a slew rate control function, having an input coupled to the data node and an output coupled to the control terminal of the first drive transistor, comprising:

   a current limiting transistor, having a conduction path and a control electrode;

   a first transistor, having a conduction path connected in series with the conduction path of the current limiting transistor between the control terminal of the first drive transistor and a first voltage, and having a control terminal coupled to the data node, wherein the first voltage will turn on the first drive transistor if applied to the control terminal thereof;

   a second transistor, having a conduction path connected on one side to the control terminal of the first drive transistor, and on another side to a second voltage, and having a control terminal coupled to the data node; and

   a bias circuit, for applying a bias voltage to the control terminal of the current limiting transistor that follows variations in the first voltage, comprising:

   a resistor divider coupled between the first voltage and a reference voltage, for producing a divided voltage, said resistor divider comprising:

   a plurality of resistors connected in series between a power supply voltage and a reference voltage; and means, connected in parallel with one of said plurality of resistors, for shorting out the one of said plurality of resistors; and

   a current mirror, having a reference leg and an output leg, wherein the current through the reference leg is controlled by the divided voltage, and wherein the output leg comprises:

   a mirror transistor, for conducting a mirrored current corresponding to the current through the reference leg; and a load, for conducting the mirrored current and for producing the bias voltage at a bias output node responsive to the mirrored current.

2. The output driver circuit of claim 1, wherein the shorting means comprises either:
   a fuse, connected in parallel with one of said plurality of resistors; or a transistor, having a conduction path connected in parallel with the one of said plurality of resistors, and having a control electrode for receiving a shorting signal.

3. The output driver circuit of claim 1, wherein the divided voltage is produced at a node between first and second groups of said plurality of resistors;
   and wherein the shorting means is connected in parallel with at least one of the first group of said plurality of resistors, and in parallel with at least one of the second group of said plurality of resistors.

4. The output driver circuit of claim 1, further comprising:

   a second drive transistor, having a conduction path connected between the output node and a second power supply voltage, and having a control terminal;

   circuitry for limiting the drive of the second drive transistor responsive to a bias voltage; and a voltage reference and regulator circuit for producing the bias voltage, comprising:

a voltage divider for generating a divided voltage based upon the power supply voltage;

a current mirror having a reference leg and a mirror leg, said reference leg receiving the divided voltage from the voltage divider and conducting a reference current responsive thereto, said mirror leg conducting a mirrored current responsive to the reference current and deriving the bias voltage based upon said mirrored current;

a bias current source, coupled to the reference leg and the mirror leg of the current mirror, for conducting a controlled current so as to control the reference current and the mirror current; and

a circuit for selecting the controlled current to be conducted by the current source.

5. The output driver circuit of claim 4 wherein the bias current source comprises a bias current source transistor, having a source/drain path connected on one side to the reference leg and mirror leg of the current mirror, and connected on another side to a reference voltage, and having a gate;

and wherein the selecting means comprises:

a current controlling device coupled between a first voltage and a common node, the common node being connected to the gate of the bias current source transistor;

a first bias reference transistor having a source/drain path connected between the common node and the reference voltage, and having a gate connected to its drain; and

a first adjustment leg, for conducting current between the common node and the reference voltage responsive to a first select signal.

6. The output driver circuit of claim 1, wherein the load comprises a linear load device.

7. An output driver circuit for driving an output node responsive to a data signal received at a data node, comprising:

a drive transistor, having a conduction path connected between the output node and a power supply voltage, and having a control terminal;

circuitry for limiting the drive of the drive transistor responsive to a bias voltage; and

a voltage reference and regulator circuit for producing the bias voltage, comprising:

a voltage divider for generating a divided voltage based upon the power supply voltage;

a current mirror having a reference leg and a mirror leg, said reference leg receiving the divided voltage from the voltage divider and conducting a reference current responsive thereto, said mirror leg conducting a mirrored current responsive to the reference current and deriving the bias voltage based upon said mirrored current;

a bias current source, coupled to the reference leg and the mirror leg of the current mirror, for conducting a controlled current so as to control the reference current and the mirror current; and

a circuit for selecting the controlled current to be conducted by the current source.

8. The output driver circuit of claim 7, wherein the bias current source comprises a bias current source transistor, having a source/drain path connected on one side to the reference leg and mirror leg of the current mirror, and connected on another side to a reference voltage, and having a gate;

and wherein the selecting means comprises:

a current controlling device coupled between a first voltage and a common node, the common node being connected to the gate of the bias current source transistor;

a bias reference transistor having a source/drain path connected between the common node and the reference voltage, and having a gate connected to its drain; and

a first adjustment leg, for conducting current between the common node and the reference voltage responsive to a first select signal.

9. The output driver circuit of claim 5 or claim 8 further comprising:

a second adjustment leg, for conducting current between the common node and the reference voltage responsive to a second select signal.

10. The output driver circuit of claim 5 or claim 8 further comprising:

a fuse circuit, for generating the first select signal.

11. The output driver circuit of claim 5 or claim 8 further comprising:

a control circuit, for generating the first select signal.

12. A method of determining the drive characteristics of an output driver circuit in an integrated circuit, wherein the output driver circuit includes a first drive transistor having a conduction path connected between an output node and a first power supply voltage, and having a control terminal, wherein the control terminal is driven to a first bias voltage in order to turn on the first drive transistor, comprising the steps of:

placing first and second selected resistance values into first and second legs of a voltage divider, respectively;

applying a power supply voltage to the voltage divider, after the placing step, to produce a divided voltage;

applying the divided voltage to the control terminal of a modulating transistor to control a reference current in a reference leg of a current mirror, said modulating transistor biased in the saturation region;

mirroring the reference current to produce a mirrored current in an output leg of the current mirror;

applying the mirrored current to a load in the output leg of the current mirror to produce the first bias voltage.

13. The method of claim 12, wherein each of the first and second legs of the voltage divider comprises a plurality of resistors in series with one another, with at least one of the plurality of resistors in each of the first and second legs having a fuse connected in parallel therewith;

and wherein the placing step comprises:

opening at least one of the fuses in at least one of the first and second legs of the voltage divider.

14. The method of claim 12, wherein each of the first and second legs of the voltage divider comprises a plurality of resistors in series with one another, with at least one of the plurality of resistors in each of the first and second legs having a shorting transistor connected in parallel therewith;

and wherein the placing step comprises:

applying signals to the shorting transistors in the first and second legs of the voltage divider to select whether the resistors in parallel therewith affect the voltage divider.

15. The method of claim 12, wherein the output driver circuit includes a second drive transistor having a conduction path connected between the output node and a second power supply voltage, and having a control terminal, wherein the control terminal of the second drive transistor is driven to a second bias voltage in order to turn on the second drive transistor;

and further comprising the steps of:

selecting a bias current;

generating the second bias voltage by controlling a current mirror having a reference leg and a mirror leg, wherein the current through the reference leg is controlled by a divided voltage based on the power supply voltage and based on the value of the selected bias current, and wherein the divided voltage defines the second bias voltage; and

applying the second bias voltage to an output buffer transistor; and

responsive to receiving a data input signal indicating that the second drive transistor in the output driver is to drive the output node, turning on the output buffer transistor to apply the second bias voltage to the control electrode of the second drive transistor.

16. A method of determining the drive characteristics of an output driver circuit in an integrated circuit, wherein the output driver circuit includes a drive transistor having a conduction path connected between an output node and a first power supply voltage, and having a control terminal, wherein the control terminal is driven to a bias voltage in order to turn on the drive transistor, comprising the steps of:

selecting a bias current;

generating the bias voltage by controlling a current mirror having a reference leg and a mirror leg, wherein the current through the reference leg is controlled by a divided voltage based on the power supply voltage and based on the value of the selected bias current, and wherein the divided voltage defines the bias voltage; and

applying the bias voltage to an output buffer transistor; and

responsive to receiving a data input signal indicating that the drive transistor in the output driver is to drive the output node, turning on the output buffer transistor to apply the bias voltage to the control electrode of the drive transistor.

17. The method of claim 15 or claim 16, wherein the step of selectring a bias current comprises:

applying a bias voltage to a reference leg of a current mirror, wherein the current conducted by the reference leg of the current mirror is controlled by the bias voltage and wherein the current mirror has a mirror leg conducting the selected bias current corresponding to the reference current times a mirror ratio; and

turning on at least one adjustment transistor coupled in parallel with the reference leg of the current mirror, to decrease the mirror ratio of the current mirror.

18. The method of claim 17, wherein the step of turning on the adjustment transistor comprises:

opening a fuse, so that the adjustment transistor is biased to an on state.

19. The method of claim 17, wherein the step of turning on the adjustment transistor comprises:

applying a logic signal to a control electrode of at least one of the adjustment transistors.

20. The method of claim 17, wherein the adjustment transistor has a control electrode coupled to a bond pad of the integrated circuit;

and wherein the step of turning on the adjustment transistor comprises:

connecting the bond pad to a fixed voltage so that the adjustment transistor is turned on.

*FIG. 1*

*FIG. 3*

FIG. 2

FIG. 4

*FIG. 5*

*FIG. 6*

EP 0 735 687 A2

FIG. 7

FIG. 8

23

EP 0 735 687 A2

FIG. 9

FIG. 11

24

FIG. 10

EP 0 735 687 A2

FIG. 12

FIG. 13